# EUROPÄISCHE PATENTANMELDUNG

(11) **EP 1 017 127 A2**
(43) Veröffentlichungstag der Anmeldung: **05.07.2000**
(21) Anmeldenummer: 99120197.1
(22) Anmeldetag: 09.10.1999
(51) Int. Cl.: H01R 4/02

(54) **Verfahren zur Verbindung zweier Oberflächen und Vorrichtung**

(30) Priorität: 29.12.1998 DE 19860587
(71) Anmelder: ROBERT BOSCH GMBH, 70442 Stuttgart (DE)
(72) Erfinder: Kleuvers, Ulrich, 73266 Bissingen (DE); Dorfmueller, Lutz, 70499 Stuttgart (DE); Reinhardt, Karl-Franz, 74189 Weinsberg (DE); Baumbach, Joerg, 70563 Stuttgart (DE); Lueder, E., 70192 Stuttgart (DE)

(57) **Zusammenfassung**

Es wird ein Verfahren vorgeschlagen, das dazu dient, Flächen mit einem geringen Kontaktwiderstand bei niedrigen Prozeßtemperaturen miteinander zu verbinden. Zunächst werden auf die Flächen Goldschichten aufgebracht, die jeweils eine spezielle Rauhigkeit aufweisen und die im Anschluß erhitzt und kurzzeitig zusammengepreßt werden, wodurch eine Verbindung entsteht.

## Beschreibung

### Stand der Technik

Die Erfindung geht aus von einem Verfahren nach der Gattung des Hauptanspruchs. Aus dem Buch John H. Lau, Flipchip Technologies Verlag McGraw Hill, 1996, ist insbesondere aus Kapitel 15.4.4 bekannt, mit Gold bedeckte Oberflächen durch Zusammenpressen und Erhitzen zu verbinden, sogenanntes 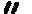 thermocompression bonding". Insbesondere wird dabei ein Halbleiterbaustein mit einem Grundsubstrat leitend verbunden. Die Oberflächen müssen für die Verbindung möglichst eben sein. Die Prozeßbedingungen, d.h. der erforderliche Druck und die erforderliche Temperatur, erfordern dabei die Verwendung von unempfindlichen Grundsubstraten, auf denen die Oberflächen aufgebracht sind, wie z.B. Aluminium. Um die für den Prozeß erforderliche Temperatur abzusenken, können durch Zusatz von Zinn metallische Eutektika erzeugt werden, die bereits bei niedrigeren Temperaturen als in dem in der Druckschrift vorgestellten Verfahren Verbindungen ermöglichen. Diese Verbindungen unterliegen jedoch aufgrund der Diffusionseigenschaften der beteiligten Materialien einer weiten Prozeßstreuung. Ein weiteres Verfahren ist die Verbindung mit einem anisotropen Klebstoff (ACF, anisotropic conductive film), bei dem der Kontaktwiderstand zwischen den Oberflächen größer ist als bei den oben genannten Verfahren.

### Vorteile der Erfindung

Das erfindungsgemäße Verfahren mit den Merkmalen des Hauptanspruchs hat demgegenüber den Vorteil, daß eine Verbindung zwischen den metallischen Oberflächen bereits bei einer niedrigeren Temperatur und einem niedrigeren Druck möglich ist. Insbesondere können auf diese Weise metallische Oberflächen verbunden werden, die auf empfindlichen Grundsubstraten wie z.B. Glas aufgebracht sind. Auch für Anwendungen, bei denen solche empfindlichen Grundsubstrate verwendet werden, steht somit ein Verbindungsverfahren zur Verfügung, bei dem der Kontakt über metallische Oberflächen erstellt wird, die zumindest ein Edelmetall, vorzugsweise Gold, aufweisen. Derartige Verbindungen sind lange haltbar, werden durch Klimaeinflüsse wie z.B. Feuchtigkeit und Wärme nicht zerstört und ihr Übergangswiderstand, d.h. der Widerstand zwischen den verbundenen Oberflächen ist außerordentlich gering und liegt im Bereich einiger Milliohm. Glassubstrate werden insbesondere für die Anwendung in einem Flüssigkristalldisplay genutzt. Die elektronischen Treiberbausteine eines Flüssigkristalldisplays können somit auf einfache, kostengünstige und haltbare Weise durch das erfindungsgemäße Verbindungsverfahren mit dem Displayglas verbunden werden.
Sofern Halbleiterbausteine bzw. deren Anschlüsse bei dem Verfahren mit anderen Flächen verbunden werden, so wird durch die niedrigere Temperatur gegenüber anderen Verbindungsverfahren die Gefährdung gesenkt, daß der Halbleiterbaustein, der i.allg. durch Erhitzen geschädigt werden kann, zerstört wird.

Es ist weiterhin von Vorteil, eine Vorrichtung vorzusehen, die das erfindungsgemäße Verfahren ausführen kann. Es ist dabei weiterhin vorteilhaft, daß durch die Vorrichtung direkt mehrere Kontakte gleichzeitig erstellbar sind, so daß bei einem Halbleiterbaustein mit vielzähligen Anschlüssen möglichst alle Anschlüsse gleichzeitig verbunden werden können.

### Zeichnung

Ein Ausführungsbeispiel der Erfindung ist in der Zeichnung dargestellt und in der nachfolgenden Beschreibung näher erläutert. In den Figuren 1 bis 6 ist der Ablauf des erfindungsgemäßen Verfahrens dargestellt. Figur 1 zeigt eine erste Fläche mit einer ersten metallischen Schicht, Figur 2 die erste Fläche mit einer weiteren, zweiten metallischen Schicht, Figur 3 eine zweite Fläche mit einer ersten metallischen Schicht, Figur 4 die zweite Fläche mit einer weiteren, zweiten metallischen Schicht. Figur 5 zeigt eine Vorrichtung zur Durchführung des Verfahrens mit der ersten und der zweiten Fläche, Figur 6 zeigt die Vorrichtung zur Durchführung des Verfahrens mit der ersten und der zweiten Fläche, die nach der Durchführung des Verfahrens miteinander verbunden sind.

### Beschreibung des Ausführungsbeispiels

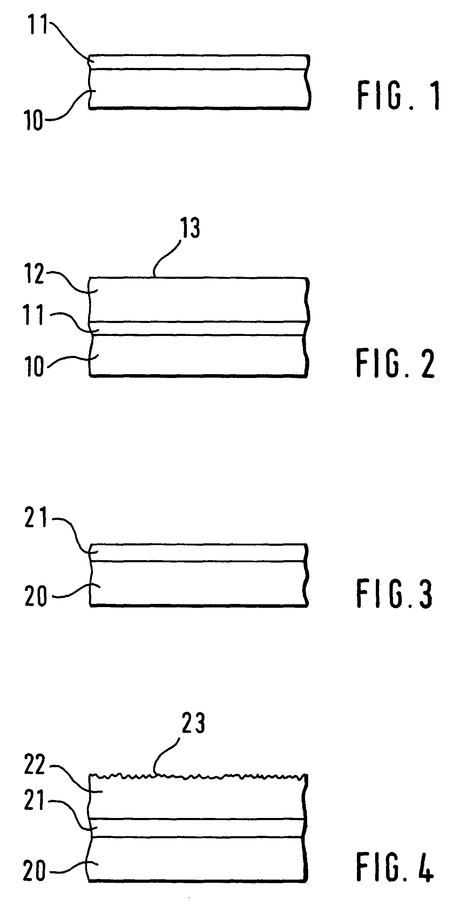

In Figur 1 ist eine erste Fläche 10 mit einer ersten metallischen Schicht 11 dargestellt. Die erste Fläche 10 kann dabei ein Metall, aber auch ein empfindlicheres Material, wie z.B. Glas sein. In einem ersten Verfahrensschritt wird auf die erste Fläche 10 eine erste metallische Schicht 11 aufgebracht. Das Material für diese erste metallische Schicht 11 ist vorzugsweise Chrom. Die erste metallische Schicht 11 dient dazu, den Halt einer weiteren, noch aufzubringenden zweiten Metallschicht zu gewährleisten. Die erste metallische Schicht ist vorzugsweise 40 bis 60 Nanometer und in einem bevorzugten Ausführungsbeispiel 50 Nanometer dick. Das Aufbringen der ersten metallischen Schicht kann jeweils durch eine der Techniken Aufdampfen, Aufsputtern oder galvanisches Aufbringen erfolgen.

In Figur 2 ist die erste Fläche 10 und die erste metallische Schicht 11 dargestellt. Auf der ersten metallischen Schicht 11 befindet sich eine erste Goldschicht 12 mit einer ersten Oberfläche 13. Die erste Oberfläche 13 der ersten Goldschicht 12 ist möglichst glatt. Die erste Goldschicht 12 weist eine hohe Reinheit von mindestens 99,9 % auf. Vorzugsweise wird für die erste Goldschicht 12 als Material Chromgold dieser Reinheit gewählt. Die Dicke der ersten Goldschicht 12 liegt in einem Bereich von 50 Nanometern bis zu einem Mikrometer und ist in einem bevorzugten Ausführungsbeispiel 100 Nanometer dick. Die erste Goldschicht 12 wird in einem zweiten Verfahrensschritt auf die erste metallische Schicht 11 aufgebracht. Auch hier kann das Aufbringen der ersten Goldschicht 12 durch Aufdampfen, durch Aufsputtern oder durch galvanisches Aufbringen erfolgen. Um jedoch eine möglichst glatte Oberfläche zu erreichen, ist Aufsputtern den anderen Techniken vorzuziehen. Die erste Fläche 10 ist nun mit einer metallischen Oberfläche mit den für das weitere erfindungsgemäße Verfahren geeigneten Eigenschaften versehen.

In Figur 3 ist eine zweite Fläche 20 mit einer ersten metallischen Schicht 21 dargestellt. Die zweite Fläche 20 ist dabei ein Metall und ist vorzugsweise ein Anschlußelement eines Halbleiterbausteins, wobei das Anschlußelement z.B. aus Aluminium besteht. Die erste metallische Schicht 21 besteht vorzugsweise aus Wolfram und ist in einer Dicke aufgebracht, die in einem Bereich von 25 bis 50 Mikrometern liegt. Außerdem eignen sich für die erste metallische Schicht 21 auch Goldlegierungen. Die erste metallische Schicht 21 dient dazu, ein Haften einer weiteren metallischen Schicht, die in einem nachfolgenden Verfahrensschritt noch aufzubringen ist, zu ermöglichen. Die erste metallische Schicht 21 wird in einem dritten Verfahrensschritt auf die zweite Fläche 20 durch Aufdampfen, Aufsputtern oder galvanisches Aufbringen aufgebracht.

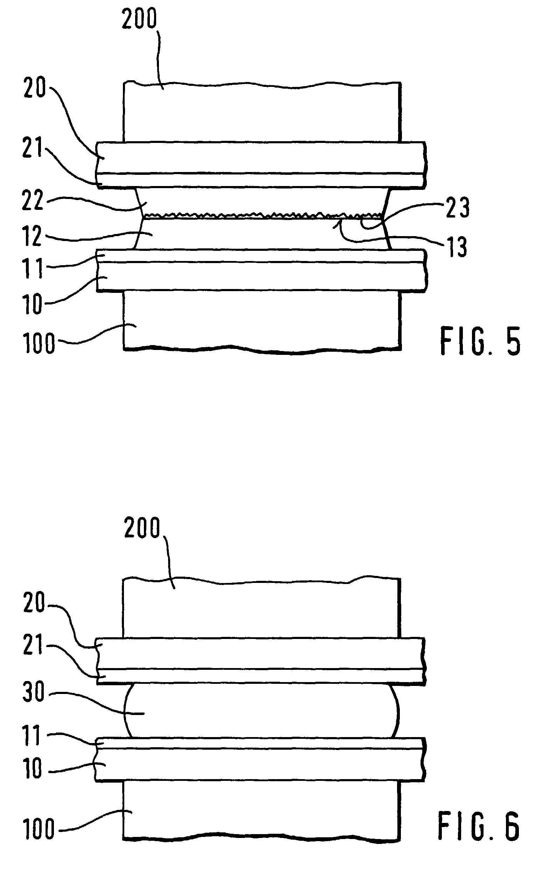

In Figur 4 ist die zweite Fläche 20 mit der ersten metallischen Schicht 21 und einer zweiten Goldschicht 22 mit einer zweiten Oberfläche 23 dargestellt. Die zweite Goldschicht 22 wird in einem vierten Verfahrensschritt durch galvanische Abscheidung auf die erste metallische Schicht 21 der zweiten Fläche 20 abgeschieden. Unter galvanischer Abscheidung ist dabei zu verstehen, daß durch Stromfluß Goldionen aus einer Lösung an der ersten metallischen Schicht 21 neutralisiert werden und sich dort ablagern. Die galvanische Abscheidung wird sehr schnell durchgeführt, vorzugsweise in einem Zeitraum von weniger als einer Stunde. Hiermit sind hohe Stromstärken verbunden. Durch die schnelle Abscheidung des Goldes ist eine polykristalline Abscheidung möglich. Die bei dem vierten Verfahrensschritt entstehende zweite Oberfläche 23 der zweiten Goldschicht 22 wird dabei sehr rauh, wobei die Rauhigkeit vorzugsweise dadurch gegeben ist, daß Vertiefungen von ca. 1 Mikrometer Tiefe in einem durchschnittlichen Abstand von 1 bis 2 Mikrometern auf der Oberfläche 23 voneinander entfernt liegen. Die zweite Goldschicht 22 wird in dem vierten Verfahrensschritt dabei in einer Dicke abgeschieden, die in einem Bereich von 1 Mikrometer bis zu 50 Mikrometern liegt. In einem bevorzugten Ausführungsbeispiel wird eine Dicke der zweiten Goldschicht 22 von 25 Mikrometern gewählt. Hiermit ist die metallische Oberfläche der zweiten Fläche für die Durchführung der weiteren, erfindungsgemäßen Verfahrensschritte fertiggestellt.

Der oben genannte erste und zweite Verfahrensschritt bezieht sich auf die erste Fläche 10, der oben genannte dritte und vierte Verfahrensschritt auf die zweite Fläche 20. Bezüglich der Durchführung der Verfahrensschritte für verschiedene Flächen soll damit keine zeitliche Reihenfolge impliziert werden. Vielmehr sind die zu verschiedenen Flächen gehörenden Verfahrensschritte voneinander zeitlich unabhängig.

In Figur 5 ist die erste Fläche 10 mit der ersten metallischen Schicht 11, der ersten Goldschicht 12 und der ersten Oberfläche 13 dargestellt. Weiterhin ist die zweite Fläche 20 mit der ersten metallischen Schicht 21, der zweiten Goldschicht 22 und der zweiten Oberfläche 23 dargestellt. Die erste Fläche 10 und die zweite Fläche 20 befinden sich zwischen einer ersten Kontaktfläche 100 und einer zweiten Kontaktfläche 200. Die erste Oberfläche 13 der ersten Goldschicht 12 und die zweite Oberfläche 23 der zweiten Goldschicht 22 berühren einander. Ferner berührt die erste Kontaktfläche 100 die erste Fläche 10 und die zweite Kontaktfläche 200 die zweite Fläche 20. Gegebenenfalls sind Haltevorrichtungen für die erste Fläche 10 an der ersten Kontaktfläche 100 und/oder für die zweite Fläche 20 an der zweiten Kontaktfläche 200 vorzusehen. Die erste Goldschicht 12 und die zweite Goldschicht 22 ragen vorzugsweise nicht seitlich über den Bereich der ersten Kontaktfläche 100 und der zweiten Kontaktfläche 200 hinaus. In einem fünften Verfahrensschritt werden die erste Kontaktfläche 100 und die zweite Kontaktfläche 200 durch eine nicht eingezeichnete Heizvorrichtung beheizt. Nach und/oder während des Heizvorgangs werden die erste Kontaktfläche 100 und die zweite Kontaktfläche 200 durch eine nicht eingezeichnete Vorrichtung derart gegeneinander bewegt, daß auf die erste Fläche 10 und die erste Fläche 20 ein Druck ausgeübt wird, so daß indirekt der Druck auf die erste Goldschicht 12 an die zweite Goldschicht 22 weitergegeben wird, so daß der Druck auch zwischen der ersten Oberfläche 13 und der zweiten Oberfläche 23 besteht. In einem bevorzugten Ausführungsbeispiel werden die erste und die zweite Kontaktfläche auf eine Temperatur in einem Bereich zwischen 200°C und 300°C erwärmt. Für einen Zeitraum zwischen 10 und 60 Sekunden wird durch die erste Kontaktfläche 100 und die zweite Kontaktfläche 200 ein Druck ausgeübt, der vorzugsweise in einem Bereich von 50 bis 140 Megapascal liegt. In einem bevorzugten Ausführungsbeispiel wird ein Druck von 100 Megapascal gewählt.

In Figur 6 ist die erste Fläche 10 mit der ersten metallischen Schicht 11 sowie die zweite Fläche 20 mit der zugehörigen, ersten metallischen Schicht 21 dargestellt. Die erste Fläche 10 und die zweite Fläche 20 befinden sich zwischen der ersten Kontaktfläche 100 und der zweiten Kontaktfläche 200, wobei die erste Fläche 10 die erste Kontaktfläche 100 und die zweite Fläche 20 die zweite Kontaktfläche 200 berührt. Zwischen der ersten metallischen Schicht 11 und der ersten metallischen Schicht 21 befindet sich nun eine dritte Goldschicht 30, die durch das Zusammenpressen und Erwärmen aus der ersten Goldschicht 12 und der zweiten Goldschicht 22 im fünften Verfahrensschritt entstanden ist. Durch diese dritte Goldschicht 30 wird nun die erste Fläche 10 über die erste metallische Schicht 11 und die erste metallische Schicht 21 mit der zweiten Fläche 20 verbunden. In einem anschließenden sechsten Verfahrensschritt kann die nunmehr mit der zweiten Fläche 20 verbundene erste Fläche 10 aus dem Bereich der ersten Kontaktfläche 100 und der zweiten Kontaktfläche 200 entnommen werden, insbesondere dadurch, daß die zweite Kontaktfläche 200 entfernt werden kann.

Ferner ist es möglich, auf einer ersten Fläche eine Vielzahl von elektrisch getrennten Bereichen nach dem zu Figur 1 und 2 beschriebenen Verfahren mit einer metallischen Oberfläche zu versehen. Verwendet man als Gegenstück eine zweite Oberfläche, die z.B. die vielzähligen Anschlüsse eines Halbleiterbausteins sein können, so kann man in einer Vorrichtung zur Durchführung des Verfahrens mit einer Vielzahl von ersten Kontaktflächen und zweiten Kontaktflächen, die gegenüberliegend positionierbar sind, in einem fünften Verfahrensschritt eine Vielzahl von Verbindungen gleichzeitig herstellen.

Ferner ist es möglich, die in dem Ausführungsbeispiel dargestellten Goldschichten durch Schichten aus einem anderen Edelmetall wie z.B. Platin oder durch Edelmetallegierungen zu ersetzen. In diesem Fall müssen die Prozeßparameter, also Druck und Temperatur, und die erforderliche Rauhigkeit der zweiten Oberfläche 23 ggf. an das andere Material der Schichten angepaßt werden.

## Patentansprüche

1. Verfahren zur Verbindung zweier Flächen, bei dem eine Verbindung zwischen einer ersten und einer zweiten Fläche durch Erwärmen und Zusammenpressen der Flächen erstellt wird, wobei vor dem Zusammenpressen und Erwärmen zumindest auf Teile der Flächen eine metallische Oberfläche aufgebracht wird, die vorzugsweise Gold aufweist, dadurch gekennzeichnet, daß die metallische Oberfläche der ersten Fläche mit einer ersten Rauhigkeit und die metallische Oberfläche der zweiten Fläche mit einer zweiten Rauhigkeit aufgebracht wird, wobei die zweite Rauhigkeit größer als die erste Rauhigkeit ist.

2. Verfahren nach Anspruch 1, dadurch gekennzeichnet, daß die metallische Oberfläche der ersten Fläche auf ein Grundsubstrat aus Glas aufgebracht wird.

3. Verfahren nach einem der vorhergehenden Ansprüche, dadurch gekennzeichnet, daß die metallische Oberfläche der zweiten Fläche auf ein Grundsubstrat aufgebracht wird, das der Anschluß eines Halbleiterbausteins ist.

4. Verfahren nach einem der vorhergehenden Ansprüche, dadurch gekennzeichnet, daß die metallische Oberfläche der ersten Fläche in einer Dicke in einem Bereich von 50 nm bis 1000 nm aufgebracht wird.

5. Verfahren nach einem der vorhergehenden Ansprüche, dadurch gekennzeichnet, daß die metallische Oberfläche der ersten Fläche in Kontakt zu dem Grundsubstrat eine Chromschicht aufweist.

6. Verfahren nach Anspruch 5, dadurch gekennzeichnet, daß die Chromschicht in einer Dicke in einem Bereich von 30 nm bis 60 nm aufgebracht wird.

7. Verfahren nach einem der vorhergehenden Ansprüche, dadurch gekennzeichnet, daß die metallische Oberfläche der zweiten Fläche galvanisch aufgebracht wird.

8. Verfahren nach einem der vorhergehenden Ansprüche, dadurch gekennzeichnet, daß die auf die zweite Fläche aufgebrachte metallische Oberfläche eine Dicke in einem Bereich von 1 Mikrometer bis 50 Mikrometer aufweist.

9. Vorrichtung zur Durchführung des Verfahrens nach einem der vorhergehenden Ansprüche, dadurch gekennzeichnet, daß zwei Kontaktflächen, von denen mindestens eine beweglich und mindestens eine beheizbar ist, derart positionierbar sind, daß zwischen den Kontaktflächen zumindest Teile der ersten und zweiten Fläche an den metallischen Oberflächen in Kontakt bringbar, zusammenpreßbar und erwärmbar sind.

10. Vorrichtung zur Durchführung des Verfahrens nach Anspruch 9, dadurch gekennzeichnet, daß die Vorrichtung über eine Vielzahl von Kontaktflächen verfügt, durch die eine Vielzahl von Verbindungen gleichzeitig erstellbar ist.
